# EUROPEAN PATENT SPECIFICATION

(11) **EP 0 635 723 B1**
(45) Date of publication and mention of the grant of the patent: **29.09.1999**
(21) Application number: 93111786.5
(22) Date of filing: 23.07.1993
(51) Int. Cl.: G01R 1/073

(54) **Buckling beam test probe assembly**
Testsondenanordnung mit Knicknadeln
Dispositif de sondes de test du type en faisceau de flambement

(43) Date of publication of application: 25.01.1995
(73) Proprietor: International Business Machines Corporation, Armonk, N.Y. 10504 (US)
(72) Inventor: Brandt, Wolfram, D-71069 Sindelfingen (DE); Marquart, Bernd, D-71093 Weil im Schönbuch (DE); Stöhr, Roland R., D-71145 Nufringen (DE)
(74) Representative: Rach, Werner, Dr.

(56) References cited:
- EP-A- 0 068 493
- EP-A- 0 233 511
- EP-A- 0 283 545
- EP-A- 0 283 545
- WO-A-90/13039
- US-A- 4 816 754
- US-A- 4 901 013
- US-A- 4 901 013
- US-A- 5 066 907
- US-A- 5 175 496

## Description

The present invention is concerned with a test probe assembly for the electrical test of devices. More particularly, the present invention refers to test probe assemblies for testing IC's having a very high contact density, i.e., a very high number of contact points to be tested.

For the electrical test on wafer level today mainly so called needle or membrane cards are used. The needle cards consist of a number of radially arranged resilient needles which correspond to the test points on the IC to be contacted. Contact on the IC is made by means of these needles.

For each contact pattern of the IC pads the cards have to be manufactured seperately. Depending on the number of needles, different designs are necessary. If, e.g., about 300 needles must be used to test a device, it is necessary to arrange these needles in up to three levels, since only a specific number of needles can be arranged in one ring. Adjusting the needles in their three axes involves much manual work due to an accuracy requirement of the needle tips of about 5 µm. Additionally, the needles are very sensitive with respect to damage and disadjustment, since they are not mechanically guided over a relatively long distance.
Increasing contact density and contact quantity, required by new IC generations, more and more limit the use of needle cards. It is not possible to cover the whole area of a test card with contact needles. The same applies for so called membrane cards which are being developed at present. Although it is possible to create ICs having a very dense arrangement of contact pads, no adequate system for testing such ICs exists at present.

Commencing with the late 1980s, buckling beam test probe assemblies have been developed. European patent 165331 describes a contact probe arrangement for electrically connecting a test system with the contact pads of a device to be tested, where wires of electrically highly conductive, resilient material are used as contact probes. These contact probes are placed onto the contact pads of the device to be tested and put under axial stress for achieving a low contact resistance, with the probes buckling laterally. This lateral buckling is advantageous since it provides a means to adapt to the irregularities in the surface of the device to be tested. The buckling contact probes adapt to different heights of the contact pads.

In US-A-4,901,013 there is described an apparatus for testing of electrical circuits having a buckling beam probe assembly with advantageous features that make it useful for contacting area arrays of test points, and for reliably establishing contact therewith. The probe elements remain essentially parallel even in the buckled state, and the probe tips execute a small "wiping" movement on the contct point. In some preferred embodiments the probe tips are shaped to result in reduced contact area.

US-A-4,843,315 discloses a contact probe arrangement including a stack of perforated plates through which extend a plurality of contact probes. The stack of perforated plates consists of two kinds of plates. The first ones have circular or square holes permitting a vertical placing of the contact probes onto the contact pads of the device to be tested. The plates of the second kind have oblong, rectangular, square, circular, elliptical or trapezoidal holes. With respect to these plates of the second kind, alternate ones are offset against the adjacent plates which are aligned relative to each other in such a manner that, if axial stress is applied, the contact probe can not buckle any further than to a part of the perforation wall limiting its maximum buckling.

However, the needle cards as well as the buckling beam contact probe arrangements do not solve the problems of contacting very dense arrangements of contact pads below about 180 µm pitch, i.e., a very exact positioning of the contact probes and the possibility to carry out a burn-in process in addition to and simultaneously with the pure electrical test. Furthermore the known assemblies are very sensitive in view of disadjustment as well as damage.

It is therefore an object of the present invention to provide a test probe assembly that allows the essential significant increase of the contact density to be tested.

This object is achieved, according to the invention, by a buckling beam test probe assembly according to claim 1.

The test probe according to the invention permits to contact and test smaller geometries, i.e., contact-pad patterns more densely spaced (< 100 µm).

A further advantage of the present invention is that the assembly is able to contact the whole area of the IC instead of only the periphery.

Furthermore, a higher signal transmission speed is achieved as compared to state of the art assemblies.
Still another advantage of the test probe assembly according to the invention is the fact that it is comparatively robust and insensitive to disadjustment and damage.

The invention will be described in more detail hereinafter with respect to the accompanying figures wherein
- Fig. 1: is a schematical view of the test probe assembly according to the invention,
- Fig. 2: shows the support of the test probe assembly on the device to be tested by stand-offs
- Fig. 3: is a cross-sectional view of a typical contact probe according to the present invention
- Fig. 4: is a more detailed view of a typical contact probe of Fig. 3,
- Fig. 5: shows the populating scheme where specific compartments are populated which are needed to test a special device, and
- Fig. 6: is a top view of the complete assembly according to the invention.

The test probe assembly according to the invention is based on the known buckling beam principle.

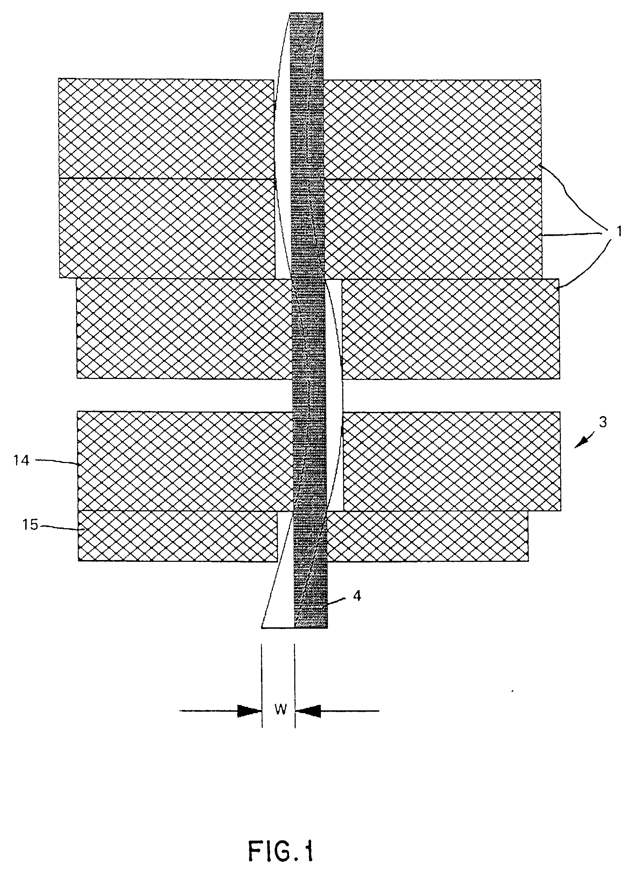

Referring to Fig. 1, the upper plates 1 of the assembly are made of high-temperature-stable polymer material (e.g. VESPEL^{R}, DELRIN^{R}). The stripper plate 3 can be made of a polymer material too, but is preferably made of silicon.

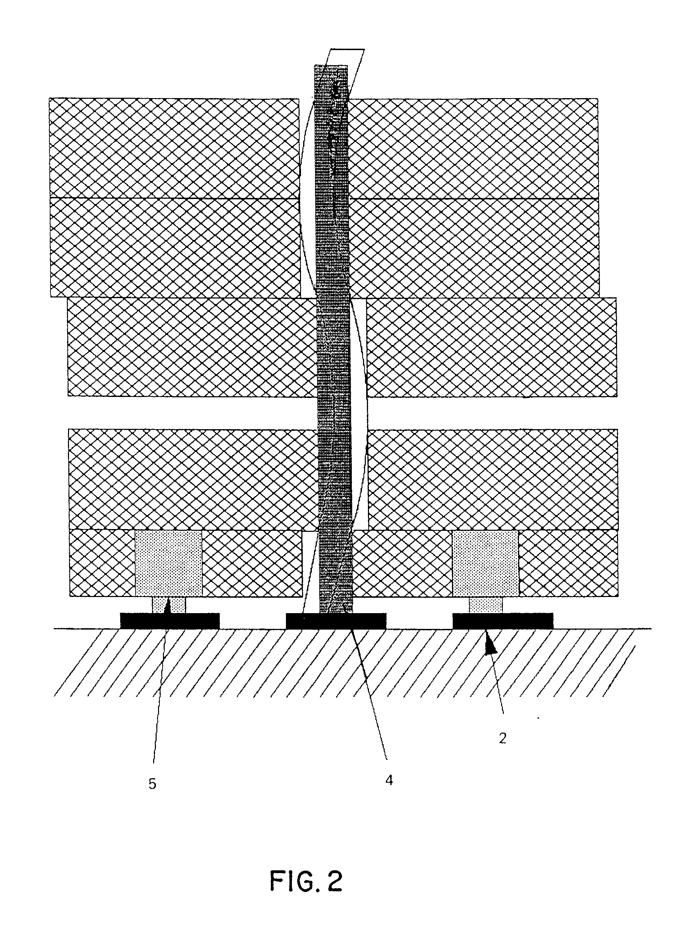

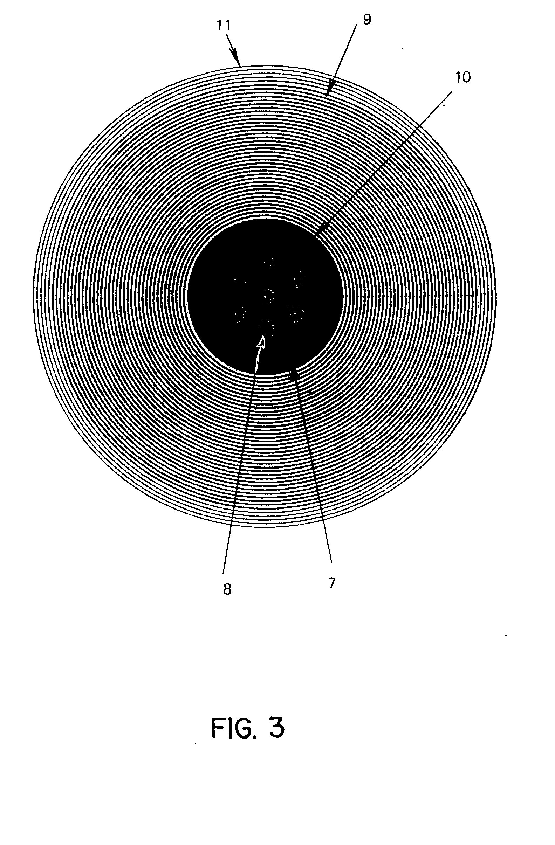

When testing IC pads 2 (Figs. 2 and 3), higher temperatures are increasingly applied to enhance the test quality. When the stripper plate 3 is made of silicon, it expands in the same degree as the IC, being made of silicon itself, when heat is applied. A slipping-off of the contact probes 4 during the test due to a mismatch of thermal coefficients is thereby eliminated.

Furthermore, a considerably more exact positioning of the contact probe 4 is possible, since, when using silicon, the typically highest accuracy which can be achieved lies below 2 µm, whereas the value is about 10 µm when polymers are used.

Of course, the stripper plate can also be made of a polymer material (VESPEL^{R}, DELRIN^{R}) instead of silicon, when temperatures are applied in a range where different thermal coefficients do not play an important role and when the accuracy has not to be very high.

Since the contact probes 4 are guided mechanically directly up to their respective tips, the contact assembly is very robust and insensitive to damage or disadjustment.

In contrast to known buckling beam probes the probe according to the invention does not support itself on the device under test with the entire surface of the stripper plate. The support takes place by stand-offs 5 (Fig. 2) which are arranged in the same array as the IC pads 2 and at the same height as the contact probes 4.

When contacting the IC no axial movement between the stripper plate 3 and the contact probes 4 themselves occurs. Therefore, no wear and subsequent debris generation of the contact probes takes place and the very sensitive ICs are not contaminated.

In order to contact devices reliably, it is important that isolating layers (oxides) which are formed on the IC pads are penetrated. With conventional buckling beam probes this was tried with a comparatively high contact pressure as compared to conventional cantilever needle cards. When using cantilever needle cards, penetration is achieved by scrubbing or wiping. The contact needle thereby rubs over the pad when contacting and wipes away and through the oxide. However, due to the different length of the needles, the amount of wiping is different for each needle. Since no individual control is possible, this can result in electrical shorts during testing.
Furthermore, the wiping distance depends on the amount of infeed of the needle card in the direction of contact, resulting in pad damage when the maximum amount is exceeded or, at best, a sliding off of the needle from the contact pad.

With the test probe assembly according to the invention, a wiping is achieved, which, in contrast to the needle card wiping principle, is exactly controllable. This is achieved by the special form of the contact probe guiding channels in the stripper plate 3. The guide channels of the stripper plate are offset in their lowest section with respect to the section immediately above it. When axial force is applied, the probes are deflected laterally in the amount dictated and allowed by the offset described. This deflection causes the wiping and the isolating oxide layer is thereby penetrated. By choosing appropriate dimensions of the contact probe guiding channels this deflection (w in Fig. 1) is predeterminable and is not dependent on the infeed of the test probe assembly in the direction of contact. Typical offset dimensions of stripper channels are 5 µm to 10 µm.

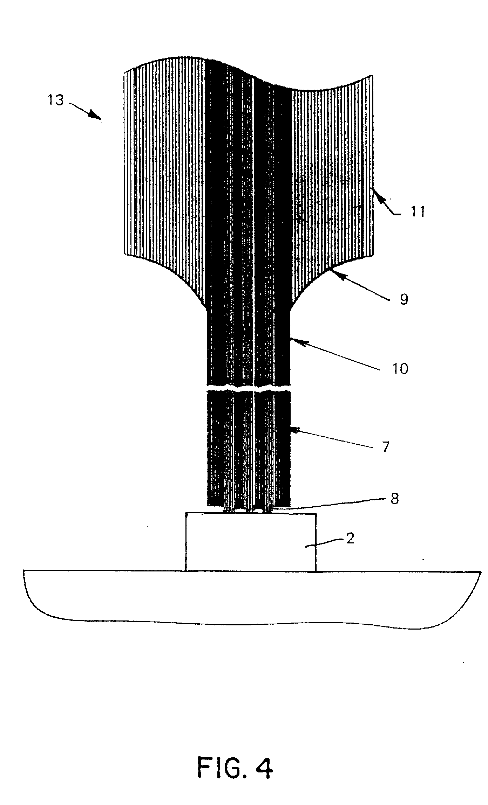

The contact probes 4 are made of a composite material. The cross-section is constructed as can be seen from Figs. 3 and 4.

The core 7, preferably made of Cu-Be, due to its mechanical properties, is the actual resilient buckling beam. Within the core, a plurality of Ag-Pd-fibres 8, preferably seven, are arranged. These fibres improve the contacting characteristics of the contact probe. They are arranged in a way that they protrude slightly from the core (Fig. 4). Due to their hardness and form the fibres, similar to dendrites are able to penetrate much easier the oxide of the contact points of the IC than a planar area of Cu-Be. The fibres preferably have a diameter of 2-10 µm.

Since the contacting force is concentrated on the Ag-Pd fibres, the desired contact behaviour is achieved and damage to the contact points of the IC-pad is drastically reduced.

A sheath comprising a highly electrical conductive material, preferably pure copper or Ag 9 is arranged around the core, thus enlarging the cross-section and reducing the ohmic resistance of the whole contact probe. The sheath is seperated from the Cu-Be core by a thin nickel layer 11, acting as an etch stop layer. It is stripped by etching to the Cu-Be core within the area 12 of the plates 1 and is maintained in the area 13 behind these plates. This design,

due to the thin cross-section of the Be-Cu wire, allows a very dense arrangement of the contact tips. The whole contact probe is insulated by a polyimide insulation layer 11.

The system proposed according to the invention permits very high (within the GHz range) test signal speed values and frequencies, respectively.

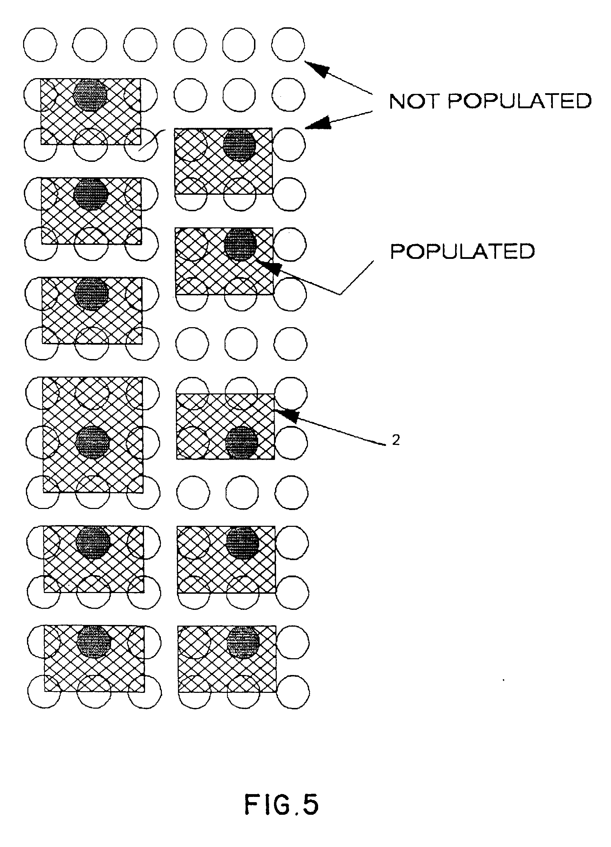

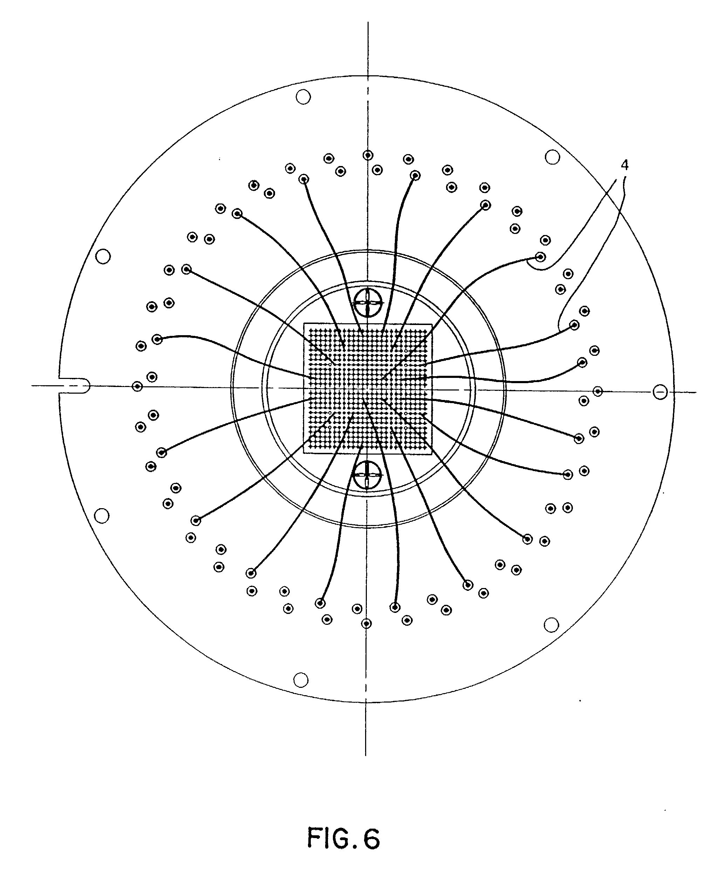

The test probe assembly according to the invention is designed with the capability of accomodating in their respective compartments a full array of probes within a predetermined area (i.e. 20 x 20 mm). The typical spacing of the array is about 100 µm. This would allow 40000 possible contacts. However, only those compartments are populated with probes which are necessary to test the respective IC. This principle is shown in Figs. 5 and 6. Theoretically an IC could be tested having the size of 20 x 20 mm and including 40000 contact pads.

Since at present only ICs are produced having a density of about 1/20 of this value, only every 20th compartment would have to be populated. When populating the compartments, the one lying nearest to the pad-center to be tested is chosen (Fig. 5). Thus, only one type of test assembly as a basis for all ICs has to be manufactured. This test probe assembly is "personalised" by respective population.

## Claims

1. A buckling beam test probe assembly for electrically testing a device, provided with a plurality of contact pads, comprising
current carrying electrically conductive contact probes (4), each of said probes is made of a composite material including an inner core (7) surrounded by an outer sheath (9), said core is comprising a resilient material and a plurality of fibers, said sheath is comprising a highly electrical conductive material, and said fibers are protruding from said core ;
a stack of perforated plates (1), wherein each of said probes passes through one perforation in each of said perforated plates; and
a stripper plate (3) positioned under said perforated plates, said stripper plate is comprised of an upper and a lower section with guiding channels, wherein the guiding channels in the lower section are offset with respect to those in the upper section so that when an axial force is applied to said probes passing through said guiding channels said probes are deflected laterally by an amount determined by said offset and by the diameter of said channels, thereby providing each of said probes with controllable wiping of said contact pads.

2. The test probe assembly as recited in claim 1, wherein said perforated plates and said stripper plate are made of a polymeric material.

3. The test probe assembly as recited in claim 1, wherein said stripper plate is made of silicon.

4. The test probe assembly as recited in claim 1, wherein the core is made of CuBe.

5. The test probe assembly as recited in claim 1, wherein said fibers protruding at one end from said core sweep at that end the surface of said contact pad.

6. The test probe assembly as recited in claim 5, wherein said fibers are made of AgPd.

7. The test probe assembly as recited in claim 5, wherein said fibers each have a diameter ranging from 2 to 10 micrometers.

8. The test probe assembly as recited in claim 5, wherein said assembly is solely supported on the device to be tested by stand-offs.

9. The test probe assembly as recited in claim 8, wherein said stand-offs are arranged in the same formation as the contact pads on the device to be tested.

10. The test probe assembly as recited in claim 8, wherein said stand-offs have the same height as the contact probes.

11. The test probe assembly as recited in claim 1, wherein said assembly further comprises contact probes in a number that matches the maximum number of contact probes of any device under test.

12. The test probe assembly as recited in claim 1, wherein said assembly further comprises compartments formed by the perforations in said stack of perforated plates and in said stripper plate, said compartments permitting the arrangement of contact probes in an array formation having a surface approximately 100 square micrometers, thereby allowing contacting a maximum of 40.000 pads.

13. The test probe assembly as recited in claim 1, wherein said core is surrounded by an etch stop layer.

14. The test probe assembly as recited in claim 13, wherein said etch stop layer is a thin layer of nickel.

15. The test probe assembly as recited in claim 1, wherein each of said probes is insulated by a polyimide insulation layer.

16. The test probe assembly as recited in claim 14, wherein said nickel layer is surrounded by said electrical conductive sheath.

## Patentansprüche

1. Testsondenanordnung mit Knicknadeln zum elektrischen Testen eines Elementes, das eine Vielzahl Kontaktflächen besitzt, umfassend:
stromführende, elektrisch leitende Kontaktsonden (4), wobei jede der Sonden aus einem Verbundmaterial besteht, das einen inneren Kern (7) aufweist, der von einer äußeren Hülle (9) umgeben ist, wobei der Kern elastisches Material und eine Vielzahl Fasern enthält, wobei die Hülle aus elektrisch sehr gut leitendem Material besteht und wobei die Fasern aus dem Kern herausragen;
einen Stapel perforierter Platten (1), wobei jede der Sonden durch ein Perforationsloch in jeder der perforierten Platten geht; und
eine Abstreifplatte (3), die sich unter den perforierten Platten befindet, wobei die Abstreifplatte aus einem oberen und einem unteren Teil mit Führungskanälen besteht, wobei die Führungskanäle im unteren Teil bezogen auf jene im oberen Teil verschoben sind, so dass beim Anlegen einer Axialkraft an die durch die Führungskanäle verlaufenden Sonden diese Sonden seitlich um einen Betrag durchgebogen werden, der von der Verschiebung und vom Durchmesser der Kanäle abhängig ist, wodurch das Schleifen jeder der Sonden über die Kontaktflächen gesteuert werden kann.

2. Testsondenanordnung nach Anspruch 1, wobei die perforierten Platten und die Abstreifplatte aus Polymerwerkstoff hergestellt werden.

3. Testsondenanordnung nach Anspruch 1, wobei die Abstreifplatte aus Silicium hergestellt wird.

4. Testsondenanordnung nach Anspruch 1, wobei der Kern aus CuBe hergestellt wird.

5. Testsondenanordnung nach Anspruch 1, wobei die Fasern, die an einem Ende aus dem Kern hervorragen, an diesem Ende die Oberfläche der Kontaktfläche überstreichen.

6. Testsondenanordnung nach Anspruch 5, wobei die Fasern aus AgPd hergestellt werden.

7. Testsondenanordnung nach Anspruch 5, wobei jede der Fasern einen Durchmesser zwischen 2 und 10 Mikrometern besitzt.

8. Testsondenanordnung nach Anspruch 5, wobei die Anordnung auf dem zu prüfenden Element nur über Abstandshalter aufliegt.

9. Testsondenanordnung nach Anspruch 8, wobei die Abstandshalter in derselben Verteilung angeordnet sind wie die Kontaktflächen des zu prüfenden Elementes.

10. Testsondenanordnung nach Anspruch 8, wobei die Abstandshalter dieselbe Höhe besitzen wie die Kontaktsonden.

11. Testsondenanordnung nach Anspruch 1, wobei die Anordnung desweiteren Kontaktsonden in einer solchen Anzahl enthält, die der maximalen Anzahl Kontaktsonden eines beliebigen zu prüfenden Elementes entspricht.

12. Testsondenanordnung nach Anspruch 1, wobei die Anordnung desweiteren Kammern enthält, die von den Perforationen in dem Stapel perforierter Platten und in der Abstreifplatte gebildet werden, wobei die Kammern eine Anordnung von Kontaktsonden in einer Matrixverteilung gestatten, deren Teilflächen ungefähr 100 Quadratmikrometer betragen, was eine Kontaktierung von maximal 40 000 Kontaktflächen ermöglicht.

13. Testsondenanordnung nach Anspruch 1, wobei der Kern von einer Atzstopschicht umgeben ist.

14. Testsondenanordnung nach Anspruch 13, wobei die Atzstopschicht eine Nickeldünnschicht ist.

15. Testsondenanordnung nach Anspruch 1, wobei jede der Sonden durch eine Isolationsschicht aus Polyimid isoliert wird.

16. Testsondenanordnung nach Anspruch 14, wobei die Nickelschicht von der elektrisch leitenden Hülle umgeben wird.

## Revendications

1. Ensemble de sondes de test aptes à la déformation pour tester électriquement un dispositif, muni d'une pluralité de zones de contact, comprenant
des sondes de contact électriquement conductrices véhiculant le courant (4), chacune desdites sondes est constituée d'un matériau composite incluant un noyau interne (7) entouré par une chemise externe (9), ledit noyau comprenant un matériau élastique et une pluralité de fibres, ladite chemise comprenant un matériau hautement électriquement conducteur, et lesdites fibres dépassant à partir dudit noyau ;
un empilement de plaques perforées (1) dans lesquelles chacune desdites sondes passe à travers une perforation dans chacune desdites plaques perforées ; et
une plaque d'extraction (3) positionnée sous lesdites plaques perforées, ladite plaque d'extraction est constituée d'une section supérieure et d'une section inférieure avec des canaux de guidage, dans laquelle les canaux de guidage dans la section inférieure sont décalés par rapport à ceux situés dans la section supérieure de sorte que lorsqu'une force axiale est appliquée auxdites sondes passant par lesdits canaux de guidage, lesdites sondes sont déviées latéralement d'une quantité déterminée par ledit décalage et par le diamètre desdits canaux, faisant de ce fait que chacune desdites sondes pourra effectuer un balayage commandable desdites zones de contact.

2. Ensemble de sondes de test selon la revendication 1, dans lequel lesdites plaques perforées et ladite plaque d'extraction sont constituées d'un matériau polymère.

3. Ensemble de sondes de test selon la revendication 1, dans lequel ladite plaque d'extraction est constituée de silicium.

4. Ensemble de sondes de test selon la revendication 1, dans lequel le noyau est constitué de CuBe.

5. Ensemble de sondes de test selon la revendication 1, dans lequel lesdites fibres dépassant au niveau d'une extrémité à partir dudit noyau balayent jusqu'à l'extrémité de la surface de ladite zone de contact.

6. Ensemble de sondes de test selon la revendication 5, dans lequel lesdites fibres sont constituées de AgPd.

7. Ensemble de sondes de test selon la revendication 5, dans lequel lesdites fibres ont chacune un diamètre s'étalant de 2 à 10 micromètres.

8. Ensemble de sondes de test selon la revendication 5, dans lequel ledit ensemble est seulement supporté sur le dispositif qui doit être testé par des montants.

9. Ensemble de sondes de test selon la revendication 8, dans lequel lesdits montants sont disposés dans la même formation que les zones de contact sur le dispositif qui doit être testé.

10. Ensemble de sondes de test selon la revendication 8, dans lequel lesdits montants ont la même hauteur que les zones de contact.

11. Ensemble de sondes de test selon la revendication 1, dans lequel ledit ensemble comprend, en outre, des sondes de contact en un nombre qui concorde avec le nombre maximal de sondes de contact de tout dispositif sous test.

12. Ensemble de sondes de test selon la revendication 1, dans lequel ledit ensemble comprend, en outre, des compartiments formés par les perforations dans ledit empilement de plaques perforées et dans ladite plaque d'extraction, lesdits compartiments permettant la disposition des sondes de contact en une formation matricielle ayant une surface d'approximativement 100 micromètres carrés, permettant de ce fait de contacter un maximum de 40 000 zones de contact.

13. Ensemble de sondes de test selon la revendication 1, dans lequel ledit noyau est entouré par une couche d'arrêt gravée.

14. Ensemble de sondes de test selon la revendication 13, dans lequel ladite couche d'arrêt gravée est une couche mince de nickel.

15. Ensemble de sondes de test selon la revendication 1, dans lequel chacune desdites sondes est isolée par une couche d'isolation en polyimide.

16. Ensemble de sondes de test selon la revendication 14, dans lequel ladite couche de nickel est entourée par une chemise électrique conductrice.
